# EUROPÄISCHE PATENTSCHRIFT

(11) **EP 1 339 204 B1**
(45) Veröffentlichungstag und Bekanntmachung des Hinweises auf die Patenterteilung: **14.06.2006**
(21) Anmeldenummer: 03450016.5
(22) Anmeldetag: 17.01.2003
(51) Int. Cl.: H04M 1/02, H04R 19/00

(54) **Kontaktierung für elektrostatische Mikrofonwandler**
Contact device for electrostatic microphone
Disposition de contacts pour microphone électrostatique

(30) Priorität: 26.02.2002 AT 2912002
(43) Veröffentlichungstag der Anmeldung: 27.08.2003
(73) Patentinhaber: AKG Acoustics GmbH, 1230 Wien (AT)
(72) Erfinder: Pribyl, Richard, 2401 Reschamend (AT)
(74) Vertreter: Patentanwälte BARGER, PISO & PARTNER

(56) Entgegenhaltungen:
- US-A- 4 291 202
- US-A- 6 011 699

## Beschreibung

Die Erfindung betrifft elektroakustische Mikrofonwandler auf elektrostatischer Basis mit einem in der Mikrofonkapsel auf einem Print angeordneten hochohmigen Vorverstärker und einem ebenfalls auf einem Print angeordneten Nachverstärker.

Elektroakustische Mikrofonwandler, die auf elektrostatischer Basis arbeiten, weisen zwei Metallflächen auf, die die Elektroden eines elektrischen Kondensators bilden. Die bewegliche Elektrode ist als eine frei schwingende und an ihrem Rand befestigte Membrane ausgeführt und wird im allgemeinen einfach Membrane genannt. Die unbewegliche Elektrode wird einfach Elektrode genannt und ist aus elektrisch leitendem und mit mehreren Öffnungen versehenem Material hergestellt. Sie ist unbeweglich, aber wegen ihrer Perforierung für den Schall durchlässig. Die Veränderungen des Schalldrucks an der Membrane des Mikrofonwandlers verursachen die Bewegung der Membrane und dadurch die Veränderungen der elektrischen Kapazität der Mikrofonkapsel.

Ähnliche Systeme sind ans der Druckschrift US-A-4291202 bekannt.

Um die Veränderungen der elektrischen Kapselkapazität in die Spannungsveränderungen an den Ausgangsanschlüssen des Mikrofons umwandeln zu können, ist es notwendig zwischen den Elektroden der Mikrofonkapsel ein elektrisches Feld aufzubauen. Das kann auf zwei Arten geschehen. Entweder wird mit Hilfe einer Spannungsquelle eine sogenannte Polarisationsspannung zwischen den Elektroden der Mikrofonkapsel aufgebaut, man spricht dann von einem Kondensatorwandler, oder es wird mit Hilfe eines sehr gut elektrisch isolierenden Materials (z.Bsp. Teflon) eine der Elektroden mit Ladungen dauerhaft beschichtet und die aufgetragene Schicht als elektrischer Ladungsträger und Speicher genutzt, ein sogenannter Elektretwandler.

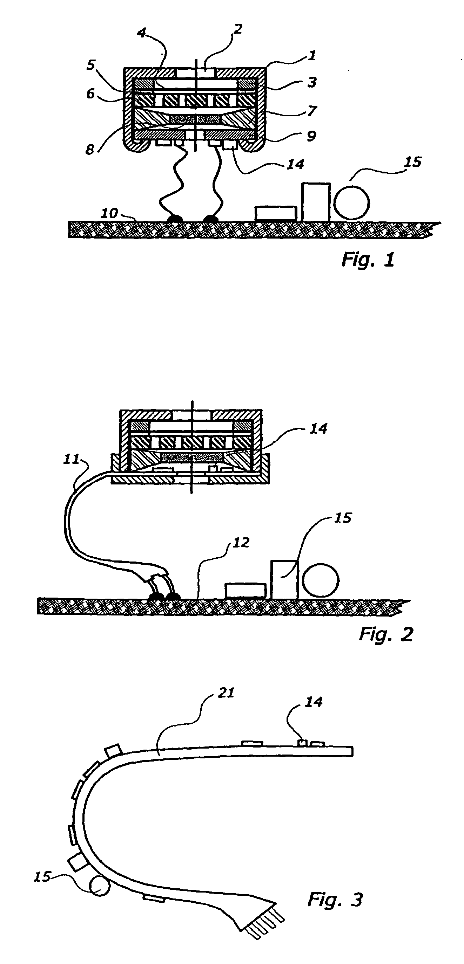

Beiden Ausführungsarten ist gemeinsam, daß das Wandlersystem, elektrisch gesehen, hochohmig ist. Das bedeutet, daß der nachgeschaltete Verstärker erstens auch mit hochohmiger Eingangsimpedanz ausgeführt werden muß, und zweitens, daß zum Zwecke der elektromagnetischen Störungsfreiheit der Verstärker in unmittelbarer Nähe der Mikrofonkapsel aufgebaut werden muß. Die letzte Bedingung wird so gewissenhaft ausgeführt, daß die erste Stufe des Mikrofonverstärkers als ein sogenannter Impedanzwandler im Gehäuse der Mikrofonkapsel selbst untergebracht wird. Ein solcher Aufbau gemäß dem Stand der Technik ist in Fig. 1, die weiter unten besprochen wird, dargestellt.

Eine so aufgebaute elektrostatische Mikrofonkapsel weist mindestens zwei elektrische Anschlüsse auf. Mit ihrer Hilfe wird die Mikrofonkapsel an den Verstärker angeschlossen. Die Kontaktierung kann entweder über Lötstellen, oder über Kontaktstellen ausgeführt werden. Beiden Kontaktierungsarten ist gemeinsam, daß sie zu einer Verteuerung der Mikrofonkapsel beitragen und vor allem aber, daß sie eine Fehlerquelle darstellen.

Die Erfindung hat sich als Aufgabe gesetzt, die elektrische Kontaktierung von Mikrofonkapseln, die als elektrostatische Wandler arbeiten, zu verbessern und zu verbilligen.

Erfindungsgemäß werden diese Ziele dadurch erreicht, dass der hochohmige Vorverstärker auf einem Flexprint angeordnet ist, dass der Flexprint über den Querschnitt des Wandlers ragt und direkt mit dem Print des Nachverstärkers verbunden ist. Dadurch entfällt das bisher notwendige, einen eigenen Bauteil bildende, Doppelkabel als Verbindung zwischen den beiden Prints und damit die Störanfälligkeit der doppelten Kontaktierung des (zweipoligen bzw. der beiden einpoligen einfachen) Kabels.

In einer Ausgestaltung ist vorgesehen, auch den Nachverstärker am entsprechend geometrisch ausgebildeten Flexprint vorzusehen, wodurch jedwedes Kontaktierungsproblem entfällt und auch der Zusammenbau vereinfacht wird.

In einer besonders bevorzugten Variante wird der Flexprint geometrisch so ausgebildet, dass der Wandler bzw. die Kapsel mittels des Flexprintes im Gerät montiert wird. Dies ist durch die mechanischen Eigenschaften des Materials, aus dem derartige Flexprints bestehen, möglich (derzeit zumeist Polyimid oder Polycarbonat).

Die Erfindung wird im folgenden anhand der Zeichnung näher erläutert. Dabei zeigt
die Fig. 1 eine Anordnung gemäß dem Stand der Technik,
die Fig. 2 eine erste erfindungsgemäße Variante,
die Fig. 3 eine besonders bevorzugte Variante der Erfindung in Seitenansicht ohne Kapsel und
die Fig. 4 eine weitere Variante in Draufsicht, ebenfalls ohne Kapsel.

Die elektrostatische Kapsel nach dem Stand der Technik ist aus Fig. 1 ersichtlich. Ein topfförmiges Kapselgehäuse 1 weist auf seiner Frontseite mindestens eine Schallöffnung 2 auf. Im Inneren der Mikrofonkapsel ist ein Membranring 3 mit einer Membrane 4 angeordnet. Ein Distanzring 5 sorgt für den notwendigen Abstand zwischen der Membrane 4 und einer perforierten Elektrode 6. Um die richtige akustische Kapselabstimmung vornehmen zu können ist eine sogenannte Reibungspille 7 vorgesehen. Sie ist üblicherweise aus Kunststoffmaterial hergestellt und weist mindestens eine Öffnung auf, die mit einem porösen Material 8 abgedeckt ist.

Die Mikrofonkapsel ist mit einem elektrischen Print 9, auf dem die elektronischen Bauteile der ersten Stufe des Verstärkers (Vorverstärker) untergebracht sind, von hinten abgeschlossen. Der Print 9 weist mindestens eine Öffnung auf, um den Schallwellen den Zugang zur Membrane auch von hinten zu gewährleisten. Der Print weist Lötstellen auf, die entweder direkt mit Anschlußdrähten oder mit steckerartigen Kontaktanschlüssen verlötet werden. Die so hergestellte Mikrofonkapsel wird mit einem, sich in einem Mikrofon oder einem anderen Gerät (Mobil- oder Drahtlostelefon, Diktier- oder ein anderes Schallaufnahmegerät) befindlichem und auf einem elektronischem Print 10 aufgebauten Nachverstärker elektrisch verbunden.

Eine erfindungsgemäße Lösung des Problems ist in Fig. 2 dargestellt. Der Aufbau der Kapsel entspricht im wesentlichen dem Aufbau der in Fig. 1 dargestellten Kapsel, wobei aber erfindungsgemäß der Print 9 (Fig. 1) durch einen sogenannten Flexprint 11 ersetzt ist. Der Flexprint wird, wie im Stand der Technik, für den Aufbau der ersten Stufe des Verstärkers (Vorverstärker 14) verwendet, er ist aber, bevorzugt mit einem dünnen Fortsatz, so lang ausgeführt, daß seine Länge ausreichend groß ist, um damit eine direkte (ohne zusätzliche Drähte) Verbindung mit dem Nachverstärker 15 am Print 12 schaffen zu können. Die Enden des Flexprints 11 können entweder direkt am Print 12 des Nachverstärkers 15 angelötet werden, oder die Kontaktierung kann mit Hilfe einer üblichen Steckverbindung erfolgen.

Die Fig. 3 zeigt, rein schematisch und unter Weglassung der Kapsel, eine weitere erfindungsgemäße Lösung. Dabei ist der Flexprint 21 so groß ausgeführt, daß auch der Nachverstärker 15 am Flexprint 21 (aber außerhalb des Kapselbereiches) aufgebaut ist. Damit kann man nicht nur die erste Stufe des Verstärkers (Vorverstärker 14) mit der Mikrofonkapsel dauerhaft elektrisch verbinden, sondern auch den Nachvcrstärker 15 mit der Mikrofonkapsel zu einer Baueinheit integrieren.

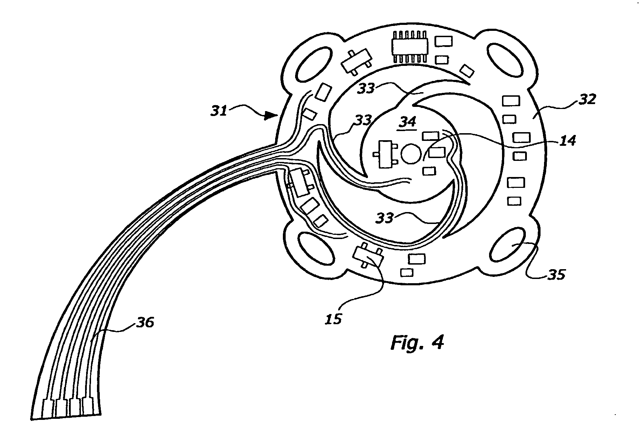

Die Fig. 4 zeigt eine weitere, besonders bevorzugte erfindungsgemäße Lösung. Dabei ist der Flexprint 31 geometrisch so ausgebildet, daß er auch die mechanische Lagerung der (nicht dargestellten) Mikrofonkapsel bewerkstelligt. Die Mikrofonkapsel sitzt dabei im zentralen Bereich 34 und wird von drei Armen 33 des Flexprintes 31 mechanisch getragen.

Mikrofonwandler müssen in den verschiedenen Geräten oft so eingebaut werden, daß sie im Geräteinneren (in vorgegebenen Grenzen) mechanisch frei schwingen können. Das ist aus Gründen der Minimierung des Körper- oder Griffschalls notwendig. Für diese Zwecke wird die Masse der Mikrofonkapsel mit der mechanischen Elastizität der Lagerung so abgestimmt, daß die mechanische Resonanzfrequenz des Systemes: Mikrofonkapsel-Mikrofonlagerung möglichst niedrig, oder außerhalb des zu übertragenden Frequenzbereiches gehalten wird.

Erfindungsgemäß wird nur der Flexprint 31 (Fig. 4) so ausgeführt, daß er die Kapsel mechanisch frei lagert bzw. hält. Zu diesem Zweck weist der Flexprint zumindest zwei Arme 33 auf, die am Gerät, beispielsweise mittels der ovalen Durchbrechungen 35 am äußeren Rand, montiert werden und die Kapsel halten. In der Fig. 4 ist eine bevorzugte Variante dargestellt, bei der drei gleichmäßig entlang des Umfangs angeordnete Arme 33 vorgesehen sind, die an ihren äußeren Enden einstückig in einen ringförmigen Printteil 32 übergehen, wodurch die Montage der gesamten Einheit erleichtert wird. Zur Verbesserung des mechanischen Schwingungsverhaltens sind die Arme 33 gekrümmt geformt und nicht genau radial ausgerichtet.

Auch in dieser Variante der Erfindung ist es möglich, den Nachverstärker 15 analog zur Ausbildung der Fig. 3 auf dem Flexprint 31 vorzusehen, entweder am ringförmigen Printteil 32 (wie angedeutet) oder auf einem (nicht dargestellten) Bereich jenseits der Nabelschnur 36, die dann u.U. mehr als nur zwei Leiterbahnen aufweist.

Die Erfindung ist nicht auf das dargestellte Ausführungsbeispiel beschränkt sondern kann verschiedentlich abgewandelt werden. So müssen insbesondere bei der Ausführungsform mit mechanischer Lagerung der Kapsel durch den Flexprint die Arme 33 nicht durch einen Ringteil 32 verbunden sein und es können, je nach Einbausituation, die Arme ungleich lang und/oder unregelmäßig bezüglich der Kapselachse angeordnet sein. Es können auch die Leiterbahnen für die Signale in unterschiedlichen Armen geführt sein und unter Umständen kann deren Kontaktierung durch die Befestigungsmittel (Schrauben, Nieten, elektrisch leitender Klebstoff, etc.) erfolgen, wodurch weitere Bauteile eingespart und weitere Montageschritte überflüssig werden.

## Patentansprüche

1. Elektroakustischer Mikrofonwandler auf elektrostatischer Basis mit einem in der Mikrofonkapsel auf einem Print (9,11,21,31) angeordneten hochohmigen Vorverstärker (14) und einem ebenfalls auf einem Print (10,12,21,31) angeordneten Nachverstärker (15), **dadurch gekennzeichnet, dass** der hochohmige Vorverstärker (14) auf einem Flexprint (11) angeordnet ist, dass der Flexprint zumindest an einer Stelle über den Querschnitt des Kapselgehäuses (1) ragt und direkt mit dem Print (12) des Nachverstärkers (15) verbunden ist.

2. Mikrofonwandler nach Anspruch 1, **dadurch gekennzeichnet, dass** der Nachverstärker (15) auf dem Flexprint (21,31) angeordnet ist.

3. Mikrofonwandler nach Anspruch 1 oder 2, **dadurch gekennzeichnet, dass** der Flexprint (31), ausgehend von dem Bereich des Kapselgehäuses (1), zumindest zwei, bevorzugt drei, Arme (33) aufweist, die zu Befestigungsstellen (35) für die mechanische Lagerung des Flexprintes (31) und des Kapselgehäuses führen.

4. Mikrofonwandler nach Anspruch 3, **dadurch gekennzeichnet, dass** die Arme (33) mit ihren äusseren Enden in einen Ringteil (32) des Flexprintes münden, in dem die Befestigungsstellen (35) vorgesehen sind.

5. Mikrofonwandler nach einem der Ansprüche 2, 3 oder 4, **dadurch gekennzeichnet, dass** der Flexprint (21,31) über einen länglichen Abschnitt (36) mit dem Gerät, in das er eingebaut ist, verbunden ist.

## Claims

1. An electrostatically based electroacoustic microphone transducer with a high-impedance preamplifier (14) arranged in the microphone capsule on a printed circuit (9,11,21,31) and with a post-amplifier (15) also arranged on a printed circuit (10,12,21,31), **characterised in that** the high-impedance preamplifier (14) is arranged on a flexible printed circuit (11), **in that** the flexible printed circuit protrudes at at least one location over the cross-section of the capsule housing (1) and is directly connected to the printed circuit (12) of the post-amplifier (15).

2. A microphone transducer according to Claim 1, **characterised in that** the post-amplifier (15) is arranged on the flexible printed circuit (21,31).

3. A microphone transducer according to Claim 1 or 2, **characterised in that**, starting from the zone of the capsule housing (1), the flexible printed circuit (31) has at least two, preferably three, arms (33) which lead to fastening points (35) for the mechanical mounting of the flexible printed circuit (31) and of the capsule housing.

4. A microphone transducer according to Claim 3, **characterised in that** at their outer ends the arms (33) merge into an annular part (32) of the flexible printed circuit, in which the fastening points (35) are provided.

5. A microphone transducer according to any one of Claims 2,3 or 4, **characterised in that** the flexible printed circuit (21,31) is connected via an elongate portion (36) to the appliance into which it is incorporated.

## Revendications

1. Microphone électro-acoustique, sur base électrostatique, avec un préamplificateur (14) de valeurs ohmiques élevées disposé dans la cartouche à microphone sur une plaquette à circuits imprimés pastillée (9, 11, 21 ,31) et avec un postamplificateur (15) également disposé sur une plaquette à circuits imprimés pastillée (10, 12, 21, 31), **caractérisé en ce que** le préamplificateur (14) de valeurs ohmiques élevées est disposé sur une plaquette à circuits imprimés pastillée flexible (11) et **en ce que** la plaquette à circuits imprimés pastillée flexible saillit au moins en un endroit par-dessus la section transversale du boîtier de la cartouche (1) et **en ce qu'**elle est directement reliée avec la plaquette à circuits imprimés pastillée (12) du postamplificateur (15).

2. Microphone selon la revendication 1, **caractérisé en ce que** le postamplificateur (15) est disposé sur la plaquette à circuits imprimés pastillée flexible (21, 31).

3. Microphone selon la revendication 1 ou 2, **caractérisé en ce qu'**en partant de la zone du boîtier de la cartouche (1), la plaquette à circuits imprimés pastillée flexible (31) comporte au moins deux, de préférence trois bras (33) qui conduisent vers des points de fixation (35) pour le logement mécanique de la plaquette à circuits imprimés pastillée flexible (31) et du boîtier de la cartouche.

4. Microphone selon la revendication 3, **caractérisé en ce que** par leurs extrémités extérieures, les bras (33) débouchent dans une partie annulaire (32) de la plaquette à circuits imprimés pastillée flexible, dans laquelle les points de fixation (35) sont prévus.

5. Microphone selon l'une quelconque des revendications 2, 3 ou 4, **caractérisé en ce que** la plaquette à circuits imprimés pastillée flexible (21, 31) est reliée sur une partie oblongue (36) avec l'appareil dans laquelle elle est montée.
